# FASCICULE DE BREVET EUROPEEN

(11) **EP 0 753 990 B1**
(45) Date de publication et mention de la délivrance du brevet: **12.04.2000**
(21) Numéro de dépôt: 96401487.2
(22) Date de dépôt: 05.07.1996
(51) Int. Cl.: H05K 3/34, H01L 21/60, H01R 12/04

(54) **Dispositif de connexion et procédé de connexion**
Verbindungsvorrichtung und Verbindungsverfahren
Connection device and process

(30) Priorité: 13.07.1995 FR 9508506
(43) Date de publication de la demande: 15.01.1997
(73) Titulaire: THOMSON-CSF, 75008 Paris (FR)
(72) Inventeur: Baumert, Eric, 92402 Courbevoie Cedex (FR); Chazelas, Jean, 92402 Courbevoie Cedex (FR)

(56) Documents cités:
- EP-A- 0 084 464
- DE-A- 4 223 280
- FR-A- 2 706 139
- US-A- 5 067 007
- IBM TECHNICAL DISCLOSURE BULLETIN, vol. 33, no. 2, NEW YORK US, pages 253-254, XP000123609 "Thermal fatigue-resistant joint for I/C packaging applications"
- PATENT ABSTRACTS OF JAPAN vol. 12, no. 389 (E-669), 17 Octobre 1989 & JP-A-63 131559 (MITSUBISHI ELECTRIC CORP.), 3 Juin 1988,
- PATENT ABSTRACTS OF JAPAN vol. 14, no. 553 (E-1010), 7 Décembre 1990 & JP-A-02 237129 (NIPPON STEEL CORP.), 19 Septembre 1990,
- PATENT ABSTRACTS OF JAPAN vol. 14, no. 496 (E-0996), 29 Octobre 1990 & JP-A-02 206141 (NIPPON STEEL CORP.), 15 Août 1990,
- PATENT ABSTRACTS OF JAPAN vol. 14, no. 496 (E-0996), 29 Octobre 1990 & JP-A-02 206139 (NIPPON STEEL CORP.), 15 Août 1990,

## Description

L'invention concerne un dispositif de connexion et procédé de connexion applicable notamment à la connexion de circuits intégrés sans broche sur une plaque de circuits imprimés.

L'industrie de l'électronique automobile, aéronautique ou des télécommunications nécessitent de réaliser des systèmes électroniques plus performants, plus compacts et plus fiables. Ces besoins de haute intégration passent par l'utilisation de composants miniaturisés et de méthodes d'assemblage adaptées. La méthode d'assemblage la plus répandue est l'utilisation de joints brasés pour le report de composants en surface. Le joint brasé a trois fonctions principales : l'interconnexion électrique, le transfert de chaleur et l'assemblage mécanique du composant sur son substrat. Un des problèmes majeurs dans l'assemblage électronique est lié aux contraintes thermiques induites par la différence de coefficient de dilatation entre le circuit imprimé et le composant. Ces contraintes conduisent à une rupture du joint brasé et en conséquence à une panne du circuit électronique associé.

L'idée de base de l'invention réside dans le fait de diminuer les contraintes imposées aux joints brasés en modifiant les propriétés élastiques du dispositif d'interconnexion (billes en Sn Pb ou billes Cu dans le cas des BGA) par utilisation de matériaux superélastiques (alliages à mémoire de forme -AMF).

La solution principale proposée est :
- le rendement de la bille en étain-plomb par une bille en AMF
   . dans ce cas, pour assurer une bonne mouillabilité entre la bille en AMF et les joints brasés en étain-plomb, il est nécessaire de recouvrir la bille en AMF par un revêtement connu pour sa bonne mouillabilité avec l'étain-plomb (Ni ou équivalent).

De nombreuses études ont été menées dans le monde sur la réalisation d'alliages à mémoire de forme (AMF) (voir en particulier l'article "General discussion : the use of shape memory actuators" , W. Van Moorleghem et al, publié par VDI/VDE - Technologiezentrum lnformationstechnik, GmBH, 1992). Les matériaux principalement utilisés sont de type Ni Ti ou des alliages de cuivre de type Cu-Al-Ni ou Cu-Al-Zn et l'effet mémoire est basé sur une transition de type martensitique-austénitique obtenue en faisant varier la température de l'alliage étudié associé à un changement de forme de l'alliage. La plage de température varie d'un type d'alliage à l'autre et est située entre -100 et + 200°C. Deux types d'effet mémoire sont à distinguer : l'effet mémoire simple sens et l'effet mémoire double sens. L'effet mémoire double sens correspond au passage réversible d'une forme haute température à une forme basse température par un simple changement de température. Associé à cet effet mémoire, les AMF présentent un comportement superélastique c'est-à-dire qu'ils sont capables de se déformer de manière réversible d'environ 10 % sous l'effet d'une contrainte mécanique.

Des dispositifs prévoient de réaliser les broches de connexion d'un composant en un matériau à mémoire de forme (voir brevets 91-300621 et 89-217193).

On peut également prévoir un joint de brasure incorporant un matériau à mémoire de forme (voir demande de brevet français N° 93 06829).

Trois types de solution sont, actuellement, utilisées pour résoudre le problème de fiabilité des joints brasés :
- Limitation du coefficient de dilatation thermique du substrat (circuit imprimé par exemple).
   Ceci est obtenu en introduisant dans l'empilage un stratifié de matériaux à très faible coefficient de dilatation thermique : - remplacement du composite résine-verre par un composite résine-aramide.
- Remplacement de la couche Cu par une couche Cu-lnvar-Cu.
   Ces deux solutions ont, respectivement les inconvénients majeurs suivants : un coefficient de dilatation en z très élevé et un accroissement de poids de la carte nue de 50 %.
- Insertion, entre le composant et le circuit imprimé, de broches qui par leur nature et leur forme réintroduisent au niveau de l'assemblage l'élasticité manquante (hauteur de la broche : 2 à 3 mm).

Le principal inconvénient de cette solution est l'accroissement de la hauteur du composant résultant, et représente donc un obstacle majeur aux besoins de haute intégration.

De plus toutes ces solutions décrites génèrent une augmentation importante de l'ordre de 20 % du coût de réalisation.

Par ailleurs, le document JP-A-2 237 129 décrit une technique de connexion utilisant des éléments en matériau à mémoire de forme.

L'invention permet donc de résoudre les difficultés indiquées ci-dessus et de perfectionner ce document IBM.

Elle concerne principalement la réalisation de connexions électriques par des éléments à base d'alliages à mémoire de forme permettant d'assembler une puce ou un composant électronique sur son substrat en vue de réduire les contraintes induites par la différence de coefficient de dilatation thermique entre ces deux éléments de l'assemblage.

L'invention concerne donc un dispositif de connexion comportant un élément conducteur en matériau à mémoire de forme comportant au moins partiellement, dans des zones destinées à être en contact avec des éléments à connecter, une surface présentant une bonne mouillabilité sur un matériau de brasure à base de plomb et/ou d'étain, caractérisé en ce que l'élément conducteur comporte un élément support en matériau polymère (polyimide par exemple) revêtu d'une couche de matériau à mémoire de forme.

L'invention concerne également un procédé de connexion comportant les étapes suivantes :
- réalisation sur chaque composant à connecter d'au moins une plage de connexion (1, 1') en matériau de brasure ;
- réalisation d'au moins un élément conducteur en matériau à mémoire de forme comportant au moins dans des zones destinées à être en contact avec les plages de connexion (1, 1'), une surface présentant une bonne mouillabilité avec le matériau à mémoire de forme et avec le matériau de brasure ;
caractérisé en ce qu'on réalise :
- la soudure de l'élément conducteur à une première plage de connexion (1) par fusion et refroidissement de cette plage de connexion ;
- la soudure de la deuxième plage de connexion (1') à l'élément conducteur par fusion et refroidissement de cette plage de connexion ;
- la soudure de l'élément conducteur à la première plage de connexion se fait par chauffage à une température et une durée permettant juste le collage de l'élément conducteur à cette première plage et que la soudure de l'élément conducteur à la deuxième plage se fait par chauffage des deux plages de connexion à une température et durant une durée permettant la fusion de ces plages de connexion.

Selon une forme de réalisation préférée de l'invention l'élément conducteur est caractérisé en ce que l'élément conducteur en matériau à mémoire de forme est enrobé par la couche de matériau présentant une bonne mouillabilité.

Les différents objets et caractéristiques de l'invention apparaîtront plus clairement dans la description qui va suivre et dans les figures annexées qui représentent :
- les figures 1a à 1c, des dispositions connues dans la technique ;
- la figure 2, un exemple d'un dispositif de connexion;
- la figure 3, un autre example d'un dispositif;

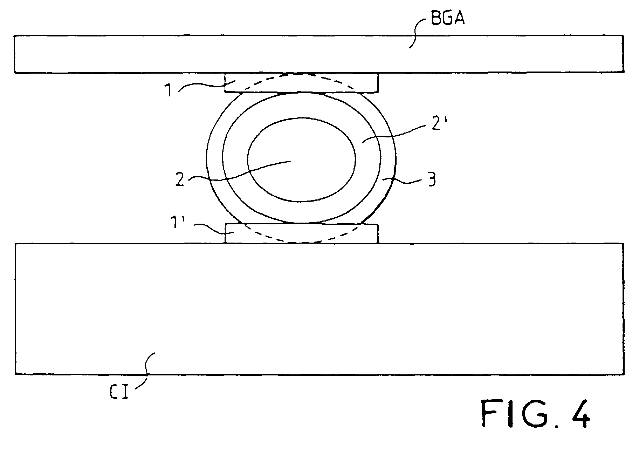

- la figure 4, un example de réalisation selon l'invention.

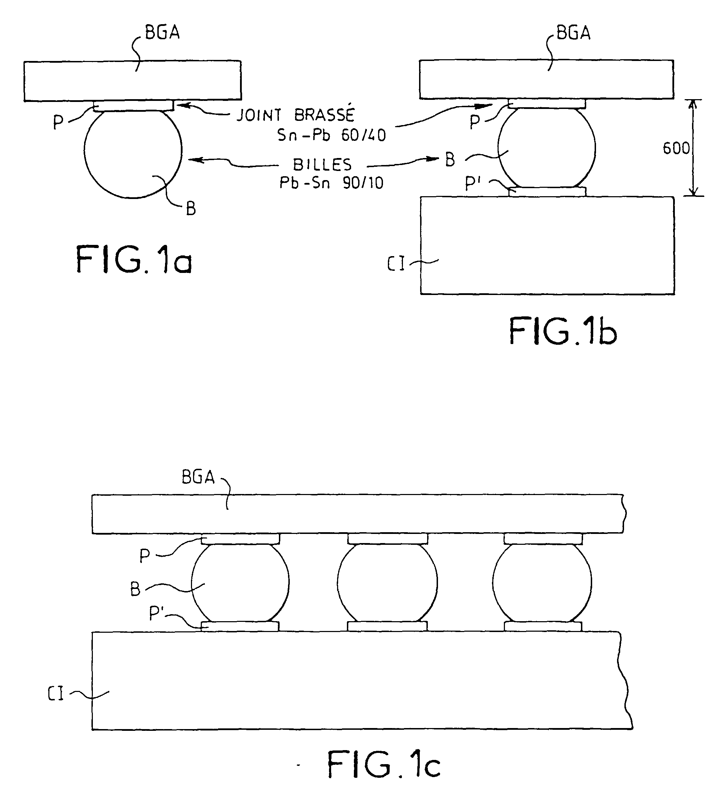

Les figures 1a et 1b représentent une méthode classique de report de composants électroniques sur circuit imprimé.

Les différents étapes de réalisation de l'interconnexion par billes pour les composants sans broches de connexion (céramique ou plastique) appelés également composants BGA (Ball Grid Array) sont les suivantes :
- apport d'alliage Sn-Pb 60-40 sur les plages d'accueil telle que P du composant BGA;
- report de billes B : Pb-Sn 90-10 dans le cas BGA céramique, Sn-Pb 60-40 dans le cas BGA plastique ;
- mise en place de l'ensemble sur une plaque de circuits imprimés Cl;
- refusion des alliages SnPb permettant l'interconnexion billes/composants.

Un circuit imprimé présentant plusieurs plages de connexion peut donc se présenter comme illustré en figure 1c.

On prévoit de réaliser les éléments de connexion, tels que des billes, en matériau à mémoire de forme.

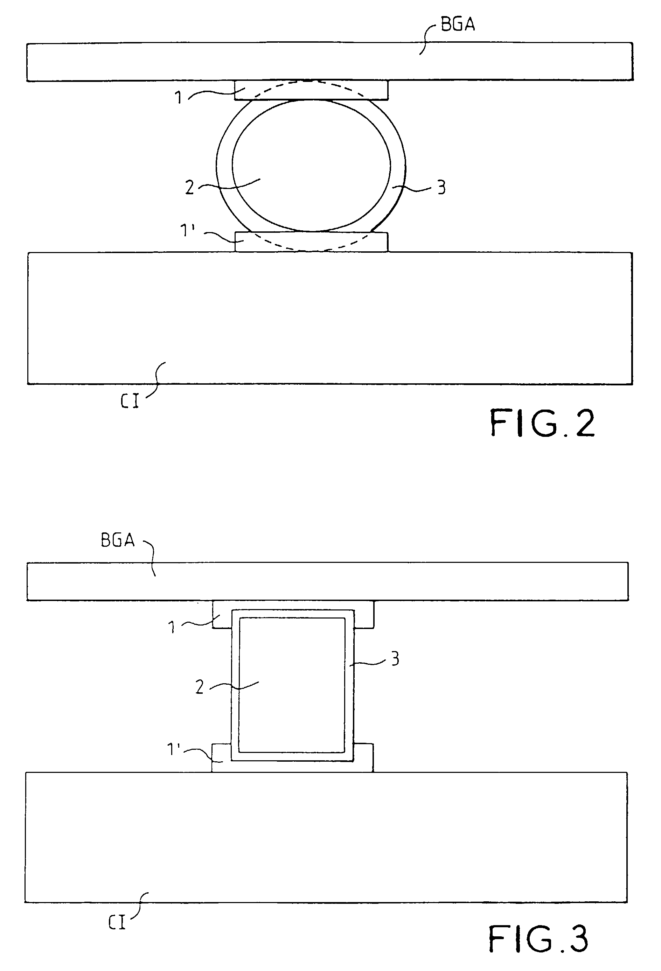

La figure 2 représente de façon schématique une telle connexion.

Pour réaliser la connexion on dispose d'un élément en matériau conducteur à mémoire de forme 2 qui permet la connexion entre un composant BGA et un circuit imprimé Cl. La connexion électrique se fait à l'aide d'un joint brasé 1 entre le composant BGA et l'élément 2 et d'un joint brasé 1' entre l'élément 2 et la plaque de circuits imprimés. De plus, selon l'invention l'élément en matériau à mémoire de forme 2 n'est pas prévu pour être fondu lors de l'opération de brasage. Il faut donc que sa surface présente une bonne mouillabilité à l'égard du matériau des joints brasés 1 et 1' ou qu'il soit revêtu d'une couche 3 d'un matériau présentant une bonne adhérence sur l'élément 2 ainsi qu'à l'égard du matériau des joints brasés 1 et 1'.

Dans le cas où les joints brasés 1 et 1' sont à base d'étain et/ou de plomb, ce revêtement 3 peut être à base de cuivre, de zinc et d'aluminium.

Dans ces conditions, la température de fusion des joints brasés 1 et 1' est inférieure à celle de l'élément de connexion 2 et de la couche 3. On peut également prévoir que la température de fusion de la couche 3 est inférieure à celle de l'élément 2.

L'élément de connexion 2 peut n'être revêtu par la couche 3 uniquement que dans les zones prévues pour être en contact et être brasées avec les joints 1 et 1'.

L'élément de connexion 2 peut être sphérique mais peut être également de forme cylindrique comme cela est représenté en figure 3. Les bases du cylindre peuvent alors servir de surfaces de connexion avec les joints 1 et 1'.

A titre d'exemple l'élément de connexion 2 peut être en un matériau à base de Ni-Ti ou de Cu-Al-Ni, ou de Cu-Al-Zn. Son diamètre dans le cas d'un élément de forme sphérique, par exemple, peut être de 0,1 mm à 0,6 mm de diamètre. L'épaisseur de la couche 3 à base de Ni ou de NiAu peut être environ de 1 µm. Dans le cas d'un élément de forme cylindrique, le diamètre peut être 0,5 mm et la hauteur de 0,5 mm par exemple.

On va maintenant décrire une forme de réalisation du procédé de connexion selon l'invention.

Les différentes étapes de ce procédé sont les suivantes.

Notre invention réside à substituer dans le procédé de réalisation du BGA les billes Sn-Pb par des billes d'AMF. Les étapes de réalisation du composant BGA seront donc les suivantes :
- apport d'alliage Sn-Pb 60-40 sur les plages d'accueil telle que 1 du composant BGA ;
- report de billes 2 recouvertes d'un traitement de surface 3. Ces billes peuvent être de même nature pour les composants plastique ou céramique ;
- fusion de l'alliage des plages de connexion 1 permettant l'interconnexion billes 2/composants BGA.

La réalisation de l'interconnexion par billes restera à la charge du composantier qui recevra les composants munis ainsi de leurs moyens de connexion.

L'utilisation des éléments en matériau de forme 2 ne modifie en rien le procédé d'assemblage du composant sur le substrat. Ce procédé reste le suivant :
- apport d'alliage Sn-Pb sur les plages d'accueil 1' du circuit imprimé ;
- report du composant BGA ;
- fusion de l'alliage Sn-Pb des plages de connexion 1' afin de réaliser l'interconnexion du composant sur le circuit imprimé.

Dans ce procédé, comme on l'a déjà mentionné précédemment, les interfaces composant-bille 2 et bille 2-circuit Cl peut être formés d'un alliage standard Sn-Pb d'où la nécessité d'un revêtement 3 de la bille 2 de type Ni-Au pour assurer une bonne mouillabilité entre la bille 2 et l'étain-plomb. Ce revêtement peut être de type Ni-Au ou tout autre métal assurant une bonne mouillabilité avec l'Sn-Pb.

On prévoit que la fusion de la plage de connexion 1 lors de la fixation des billes au composant BGA se fait à une température juste nécessaire pour permettre le collage des billes au composant BGA et que lors de l'assemblage du composant BGA sur la plaque de circuit intégré, le chauffage de la plage de connexion 1' permet le chauffage de la plage de connexion 1 et la réalisation d'une véritable connexion brasée.

Selon l'invention, un élément de connexion est en polymère 2 (polyimide par exemple) présentant des propriétés de déformation compatibles de l'application au report de composants de type BGA.

L'élément de connexion 2 est revêtu d'une couche de matériau à mémoire de forme 2', elle-même revêtue d'une couche en matériau 3 présentant une bonne mouillabilité avec une brasure à base de plomb ou d'étain-plomb. Dans cette variante, le matériau polymère 2 peut être un polymère conducteur.

L'invention présente les avantages suivants :
- augmentation de l'intégration par diminution de la hauteur du composant-billes plus petites que broches (0.6 mm au lieu de 2 à 3 mm) ;
- augmentation de la fiabilité de l'assemblage par l'utilisation de la superélasticité des billes en AMF ;
- utilisation des propriétés superélastiques des matériaux à mémoire de forme pour réduire les contraintes de cisaillement induites par la différence de coefficient de dilatation thermique entre le composant (BGA ou autre) et le substrat (circuit imprimé).

Les applications d'un tel dispositif et d'un tel procédé de connexion peuvent être les suivantes :
- circuits électroniques à haute densité ;
- report de composants céramiques ;
- BGA (Ball Grid Arrays) ;
- Bumps pour Flip-Chip ;
- Report de MCM (Multi Chip Module).

## Revendications

1. Dispositif de connexion comportant un élément conducteur en matériau à mémoire de forme comportant au moins partiellement, dans des zones destinées à être en contact avec des éléments à connecter, une surface présentant une bonne mouillabilité sur un matériau de brasure à base de plomb et/ou d'étain, caractérisé en ce que l'élément conducteur comporte un élément support (2) en matériau polymère revêtu d'une couche de matériau à mémoire de forme (2').

2. Procédé de connexion comportant les étapes suivantes :
- réalisation sur chaque composant à connecter d'au moins une plage de connexion (1, 1') en matériau de brasure ;
- réalisation d'au moins un élément conducteur en matériau à mémoire de forme comportant au moins dans des zones destinées à être en contact avec les plages de connexion (1, 1'), une surface présentant une bonne mouillabilité avec le matériau à mémoire de forme et avec le matériau de brasure ;
caractérisé en ce qu'on réalise :
- la soudure de l'élément conducteur à une première plage de connexion (1) par fusion et refroidissement de cette plage de connexion ;
- la soudure de la deuxième plage de connexion (1') à l'élément conducteur par fusion et refroidissement de cette plage de connexion ;
la soudure de l'élément conducteur à la première plage de connexion se faisant par chauffage à une température et une durée permettant juste le collage de l'élément conducteur à cette première plage et la soudure de l'élément conducteur à la deuxième plage se fait par chauffage des deux plages se faisant de connexion à une température et durant une durée permettant la fusion simultanée de ces plages de connexion.

3. Dispositif ou procédé selon l'une des revendications 1 ou 2, caractérisé en ce que ladite surface comporte une couche (3) présentant une bonne adhérence avec le matériau à mémoire de forme et une bonne mouillabilité avec le matériau de brasure.

4. Dispositif ou procédé de connexion selon la revendication 3, caractérisé en ce que l'élément conducteur en matériau à mémoire de forme est enrobé par la couche (3) de matériau présentant une bonne mouillabilité.

5. Dispositif ou procédé de connexion selon la revendication 3, caractérisé en ce que la température de fusion du matériau à mémoire de forme et celle du matériau à bonne mouillabilité sont supérieures à celle du matériau de brasure, le matériau de brasure étant à base de plomb et/ou d'étain.

6. Dispositif ou procédé selon la revendication 5, caractérisé en ce que la température de fusion du matériau à mémoire de forme est supérieure à celle de la couche (3) de matériau présentant bonne mouillabilité.

7. Dispositif ou procédé selon l'une des revendications 1 ou 2, caractérisé en ce que le matériau à mémoire de forme est à base de Ni-Ti, ou de Cu-Al-Ni ou de Cu-Al-Zn.

8. Dispositif ou procédé selon la revendication 3, caractérisé en ce que la couche (3) de matériau présentant une bonne mouillabilité est à base de nickel ou de nickel/or.

9. Dispositif ou procédé selon l'une des revendications 1 ou 2, caractérisé en ce que l'élément conducteur est de forme sphérique ou cylindrique.

10. Procédé de connexion selon la revendication 2, caractérisé en ce que les plages de connexion sont à base de plomb et/ou d'étain.

11. Procédé de connexion selon la revendication 9, caractérisé en ce que l'élément conducteur étant de forme cylindrique, les bases du cylindre sont utilisées pour être connectées aux plages de connexion.

## Patentansprüche

1. Verbindungsvorrichtung, mit einem Leiterelement aus einem formerhaltenden Material, das in den Zonen, die für den Kontakt mit den zu verbindenden Elementen bestimmt sind, wenigstens teilweise eine Oberfläche aufweist, die eine gute Benetzbarkeit mit einem Lötmaterial auf der Basis von Blei und/oder Zinn besitzt, dadurch gekennzeichnet, daß das Leiterelement ein Trägerelement (2) aus einem Polymermaterial enthält, das mit einer Schicht (2') aus formerhaltendem Material beschichtet ist.

2. Verbindungsverfahren, das die folgenden Schritte enthält:
- Herstellen wenigstens eines Verbindungsbereichs (1, 1') aus Lötmaterial auf jedem zu verbindenden Bauteil;
- Herstellen wenigstens eines Leiterelements aus formerhaltendem Material, das wenigstens in den Zonen, die für den Kontakt mit den Verbindungsbereichen (1, 1') bestimmt sind, eine Oberfläche aufweist, die eine gute Benetzbarkeit mit dem formerhaltenden Material und mit dem Lötmaterial besitzt;
dadurch gekennzeichnet, daß
- das Verlöten des Leiterelements mit einem ersten Verbindungsbereich (1) durch Schmelzen und Abkühlen dieses Verbindungsbereichs; und
- das Verlöten des zweiten Verbindungsbereichs (1') mit dem Leiterelement durch Schmelzen und Abkühlen dieses Verbindungsbereichs ausgeführt wird;
wobei das Verlöten des Leiterelements mit dem ersten Verbindungsbereich durch Erwärmen auf eine Temperatur und während einer Dauer erfolgt, die gerade das Kleben des Leiterelements auf diesen ersten Bereich ermöglichen, und das Verlöten des Leiterelements mit dem zweiten Bereich durch Erwärmen der beiden verbundenen Bereiche auf eine Temperatur und während einer Dauer erfolgt, die die gleichzeitige Schmelzung dieser Verbindungsbereiche ermöglichen.

3. Vorrichtung oder Verfahren nach einem der Ansprüche 1 oder 2, dadurch gekennzeichnet, daß die Oberfläche eine Schicht (3) aufweist, die eine gute Haftung mit dem formerhaltenden Material und eine gute Benetzbarkeit mit dem Lötmaterial besitzt.

4. Verbindungsvorrichtung oder -verfahren nach Anspruch 3, dadurch gekennzeichnet, daß das Leiterelement aus formerhaltendem Material von der Schicht (3) aus dem eine gute Benetzbarkeit aufweisenden Material umhüllt ist.

5. Verbindungsvorrichtung oder -verfahren nach Anspruch 3, dadurch gekennzeichnet, daß die Schmelztemperatur des formerhaltenden Materials und diejenige des Materials mit guter Benetzbarkeit höher als diejenige des Lötmaterials sind, wobei das Lötmaterial ein Material auf der Basis von Blei und/oder Zinn ist.

6. Vorrichtung oder Verfahren nach Anspruch 5, dadurch gekennzeichnet, daß die Schmelztemperatur des formerhaltenden Materials größer als diejenige der Schicht (3) aus dem eine gute Benetzbarkeit aufweisenden Material ist.

7. Vorrichtung oder Verfahren nach einem der Ansprüche 1 oder 2, dadurch gekennzeichnet, daß das formerhaltende Material ein Material auf der Basis von Ni-Ti oder Cu-Al-Ni oder Cu-Al-Zn ist.

8. Vorrichtung oder Verfahren nach Anspruch 3, dadurch gekennzeichnet, daß die Schicht (3) aus dem eine gute Benetzbarkeit aufweisenden Material ein Material auf der Basis von Nickel oder Nickel/Gold ist.

9. Vorrichtung oder Verfahren nach einem der Ansprüche 1 oder 2, dadurch gekennzeichnet, daß das Leiterelement eine sphärische oder zylindrische Form besitzt.

10. Verbindungsverfahren nach Anspruch 2, dadurch gekennzeichnet, daß die Verbindungsbereiche Bereiche auf der Basis von Blei und/oder Zinn sind.

11. Verbindungsverfahren nach Anspruch 9, dadurch gekennzeichnet, daß das Leiterelement eine zylindrische Form besitzt, wobei die Grundflächen des Zylinders dazu verwendet werden, mit den Verbindungsbereichen verbunden zu werden.

## Claims

1. A connection device comprising a conductor element which comprises a shape memory material, and which comprises, at least in part, in areas intended to be in contact with elements to be connected and a surface which exhibits good wettability by a brazing material based on lead and/or tin, characterised in that the conductor element comprises a support element (2) made of polymeric material which is coated with a layer of shape memory material (2').

2. A connection process comprising the following stages:
- providing at least one connection region (1,1') comprising brazing material on each component to be connected;
- providing at least one conductor element which comprises shape memory material, and which comprises, at least in areas intended to be in contact with the connection regions (1, 1'), a surface which exhibits good wettability by the shape memory material and by the brazing material;
characterised in that:
- the conductor element is soldered to a first connection region (1) by melting and cooling said connection region;
- the second connection region (1') is soldered to the conductor element by melting and cooling this second connection region;
wherein the conductor element is soldered to the first connection region by heating to a temperature and for a duration which just permit the conductor element to be bonded to said first region, and the conductor element is soldered to the second region by heating the two regions forming the connection to a temperature and for a duration which permit the simultaneous melting of said connection regions.

3. A device or process according to either one of claims 1 or 2, characterised in that said surface comprises a layer (3) which exhibits good adhesion to the shape memory material and good wettability by the brazing material.

4. A connection device or process according to claim 3, characterised in that the conductor element comprising shape memory material is coated by the layer (3) of material which exhibits good wettability.

5. A connection device or process according to claim 3, characterised in that the melting temperature of the shape memory material and that of the material which exhibits good wettability are higher than that of the layer (3) based on lead and/or tin.

6. A device or process according to claim 5, characterised in that the melting temperature of the shape memory material is higher than that of material which exhibits good wettability.

7. A device or process according to either one of claims 1 or 2, characterised in that the shape memory material is based on Ni-Ti, or on Cu-Al-Ni or Cu-Al-Zn.

8. A device or process according to claim 3, characterised in that the layer (3) of material which exhibits good wettability is based on nickel or on nickel/gold.

9. A device or process according to either one of claims 1 or 2, characterised in that the conductor element is of spherical or cylindrical shape.

10. A connection process according to claim 2, characterised in that the connection regions are based on lead and/or tin.

11. A connection process according to claim 9, characterised in that the conductor element is of cylindrical shape and the bases of the cylinder are used for connection to the connection regions.
